# EUROPEAN PATENT APPLICATION

(11) **EP 2 287 920 A1**
(43) Date of publication of application: **23.02.2011**
(21) Application number: 08877745.3
(22) Date of filing: 30.10.2008
(51) Int. Cl.: H01L 31/04

(54) **PHOTOELECTRIC CONVERSION APPARATUS AND PROCESS FOR PRODUCING PHOTOELECTRIC CONVERSION APPARATUS**

(71) Applicant: Mitsubishi Heavy Industries, Ltd., Tokyo 108-8215 (JP)
(72) Inventor: NISHIMIYA, Tatsuyuki, Nagasaki-shi Nagasaki 851-0392 (JP); MASHIMA, Hiroshi, Nagasaki-shi Nagasaki 851-0392 (JP); MIYAHARA, Hiroomi, Nagasaki-shi Nagasaki 851-0392 (JP); KAWAMURA, Keisuke, Nagasaki-shi Nagasaki 851-0392 (JP); NAKANO, Youji, Nagasaki-shi Nagasaki 851-0392 (JP)
(74) Representative: Bongiovanni, Simone
(86) International application number: PCT/JP2008/069790
(87) International publication number: WO 2010/050034

(57) **Abstract**

A photoelectric conversion apparatus (100) having a photovoltaic layer (3) comprising a crystalline silicon i-layer (42) formed on a large surface area substrate (1) of not less than 1 m², wherein the crystalline silicon i-layer comprises regions in which the Raman peak ratio, which is the ratio, within the substrate (1) plane, of the Raman peak intensity of the crystalline silicon phase relative to the Raman peak intensity of the amorphous silicon phase, is within a range from not less then 3.5 to not more than 8.0, and the surface area proportion for those regions within the substrate (1) plane having a Raman peak ratio of not more than 2.5 is not more than 3%. In this manner, by adjusting the crystallinity of the crystalline silicon i layer to a crystallinity that yields a high output but is prior to the occurrence of high-brightness reflective regions, thereby restricting the surface area proportion of the high-brightness reflective regions, a photovoltaic device that exhibits a high output can be realized.

## Description

### Technical Field

The present invention relates to a photovoltaic device, and relates particularly to a thin-film solar cell in which the electric power generation layer is formed by deposition.

### Background Art

One known example of a photovoltaic device that converts the energy from sunlight into electrical energy is a thin-film silicon-based solar cell comprising a photovoltaic layer formed by using a plasma-enhanced CVD method or the like to deposit thin films of a p-type silicon-based semiconductor (p-layer), an i-type silicon-based semiconductor (i-layer) and an n-type silicon-based semiconductor (n-layer). Among thin-film silicon-based solar cells, tandem-type solar cells in which a photovoltaic layer comprising an i-layer composed of amorphous silicon (an amorphous silicon i-layer) and a photovoltaic layer comprising an i-layer composed of crystalline silicon (a crystalline silicon i-layer) are stacked together are used to improve the conversion efficiency of the solar cell.

In order to improve the conversion efficiency of a thin-film silicon-based solar cell, improving the quality of the crystalline silicon layers, and particularly the crystalline silicon i-layer, is essential. One of the indicators of the quality of the crystalline silicon i-layer is the crystallinity.

Patent Citation 1 discloses a correlation between the crystallinity of a crystalline silicon i-layer following deposition and the conversion efficiency of the solar cell. In Patent Citation 1, the crystallinity of the crystalline silicon i-layer is represented by the ratio, within a Raman spectrum, of the peak intensity Ic of the crystalline silicon phase (the peak intensity near a frequency of 520 cm⁻¹) relative to the peak intensity Ia of the amorphous silicon phase (the peak intensity near a frequency of 480 cm⁻¹) (namely, the Raman peak ratio Ic/Ia). In a single-structure solar cell having a photovoltaic layer comprising mainly crystalline silicon, the electric power generation efficiency of the solar cell improves when this Raman peak ratio for the crystalline silicon i-layer is within a range from not less than 3.5 to not more than 8.
Patent Citation 1: Japanese Unexamined Patent Application, Publication No. 2008-66343

### Disclosure of Invention

The present invention has an object of providing a photovoltaic device having a large surface area substrate that exhibits a high output, as well as a process for producing such a device.

By lowering the Raman peak ratio of the crystalline silicon i-layer in the manner described in Patent Citation 1, the output of a crystalline silicon solar cell can be increased. It is thought that this increase is because the existence of an appropriate amount of an amorphous phase in the crystalline silicon i-layer electrically deactivates defects that exist at the grain boundaries of the crystalline silicon phase.
However, when an attempt was made to deposit a crystalline silicon i-layer under conditions that yield an average value for the Raman peak ratio of not less than 3.5 and not more than 8 using a large surface area substrate exceeding 1 m², it was found that high-brightness reflective regions appeared on portions of the surface. The inventors of the present invention discovered that these high-brightness reflective regions were regions in which the size of the asperity at the surface of the crystalline silicon i-layer was in the vicinity of visible light, and therefore scattering of the visible light caused the regions to appear brighter. Further, the inventors also discovered that these high-brightness reflective regions were a phenomenon that occurred when the crystallinity of the crystalline silicon i-layer was low, particularly when the Raman peak ratio for the crystalline silicon i-layer within the high-brightness reflective region was 2.5 or lower, and therefore significantly lower than the surrounding regions.

Generally, in a solar cell comprising a crystalline silicon i-layer, as the crystallinity (Raman peak ratio) of the crystalline silicon i-layer decreases, the open-circuit voltage and the fill factor increase, but the short-circuit current is also known to decrease, and this decrease in the short-circuit current causes a reduction in the output of the solar cell. Further, the crystallinity of the crystalline silicon i-layer varies depending on the deposition conditions. Accordingly, it was discovered that in order to increase the output of a solar cell module, it is preferable that the crystalline silicon i-layer is deposited with the deposition conditions controlled such that high-brightness reflective regions do not occur and the short-circuit current does not decrease, while the crystallinity (Raman peak ratio) of the crystalline silicon i-layer is lowered to increase the open-circuit voltage and the fill factor.

Furthermore, from the viewpoint of durability, it is preferable that high-brightness reflective regions do not occur in the crystalline silicon i-layer. It is known that, generally, those conditions immediately prior to the formation of an amorphous silicon phase yield the highest internal stress within the layer. In other words, a high-brightness reflective region has higher internal stress than the surrounding regions, and therefore the high-brightness reflective region may act as an origin for partial detachment of the photovoltaic layer comprising the crystalline silicon i-layer, resulting in a deterioration in the output of the solar cell. Partial detachment of the photovoltaic layer is more likely in cases where a high-brightness reflective region coincides with the edge of the substrate or an etching line formed by laser scribing, which is an essential technique that is used when performing integration to produce a solar cell module.

However, in a plasma-enhanced CVD apparatus used for depositing a crystalline silicon i-layer onto a large surface area substrate, a variety of factors, including the substrate temperature distribution, the raw material gas distribution, the density distribution of the high-frequency electric power supplied to the discharge electrode, and differences in the current return path for the supplied high-frequency electric power due to the electrical configuration, mean that achieving uniform deposition conditions across the substrate plane, and therefore a uniform distribution in the quality of the crystalline silicon i-layer, has proven difficult.

Accordingly, the inventors of the present invention specified a permissible surface area for high-brightness reflective regions for a photovoltaic device that uses a large surface area substrate, and by adjusting the crystallinity (Raman peak ratio) of the crystalline silicon i-layer formed on the large surface area substrate to a low crystallinity that enabled a high output to be obtained but was prior to the level at which high-brightness reflective regions occurred, were able to produce a photovoltaic device that exhibited superior output.

In other words, the present invention provides a photovoltaic device having a photovoltaic layer comprising a crystalline silicon i-layer formed on a large surface area substrate of not less than 1 m², wherein the crystalline silicon i-layer comprises regions in which the average value of the Raman peak ratio, which is the ratio of the Raman peak intensity of the crystalline silicon phase relative to the Raman peak intensity of the amorphous silicon phase, is within a range from not less then 3.5 to not more than 8.0, and the surface area proportion for those regions within the substrate plane having a Raman peak ratio of not more than 2.5 is not more than 3%.

With a large surface area substrate, a substrate in-plane distribution occurs for the crystallinity (Raman peak ratio) of the crystalline silicon i-layer. In the present invention, the majority of the crystalline silicon i-layer is of a low crystallinity prior to the level at which high-brightness reflective regions occur, and is composed of regions in which the average value for the Raman peak ratio is within a range from not less then 3.5 to not more than 8.0, a condition that yields a high conversion efficiency. Moreover, high-brightness reflective regions which exhibit reduced conversion efficiency have a Raman peak ratio or not more than 2.5, and the surface area proportion of these regions is not more than 3%. As a result, a photovoltaic device having a large surface area substrate and a high output can be produced. By reducing the surface area of the high-brightness reflective regions, detachment of the photovoltaic layer at the laser etching lines or substrate edges is prevented.

In the above invention, the surface area proportion of regions within the substrate plane for which the Raman peak ratio is within a range from not less then 3.5 to not more than 8.0 is preferably not less than 80%.

By ensuring that, as described above, the surface area proportion of regions for which the Raman peak ratio is not less then 3.5 to not more than 8.0 is not less than 80%, a photovoltaic device having a large surface area substrate and a high output can be produced.

Furthermore, the present invention also provides a process for producing a photovoltaic device having a photovoltaic layer comprising a crystalline silicon i-layer formed on a large surface area substrate of not less than 1 m², the process comprising: depositing the crystalline silicon i-layer, measuring the surface area proportion of those regions of the crystalline silicon i-layer for which the Raman peak ratio, which is the ratio of the peak intensity of the crystalline silicon phase relative to the peak intensity of the amorphous silicon phase, is not more than 2.5, and adjusting the deposition conditions for the crystalline silicon i-layer so that this surface area proportion of those regions for which the Raman peak ratio is not more than 2.5 is not more than 3%.

In this manner, by reflecting the surface area proportion of high-brightness reflective regions having a Raman peak ratio of 2.5 or less in the deposition conditions for the crystalline silicon i-layer, the substrate in-plane distribution of the crystallinity of the crystalline silicon i-layer deposited on a large surface area substrate can be controlled. As a result, the surface area proportion of high-brightness reflective regions within the substrate plane can be restricted to 3%, enabling the production of a high-output photovoltaic device. Further, because film detachment at laser etching lines or substrate edges can be prevented, the production yield of the photovoltaic device can be increased.

In the above invention, the conditions for depositing the crystalline silicon i-layer are preferably adjusted so that the surface area proportion of those regions within the substrate plane for which the Raman peak ratio is not less than 3.5 and not more than 8.0 is not less than 80%. This enables the high-output photovoltaic device to be produced with good stability.

In the above invention, the conditions for depositing the crystalline silicon i-layer may be adjusted so that the cell voltage falls within a predetermined range.

By adjusting the deposition conditions for the crystalline silicon i-layer using a measured value of the cell voltage in this manner, the output can be improved without lowering the short-circuit current. In other words, a high-performance photovoltaic device can be provided.

The silane partial pressure and the high-frequency electric power density during deposition of the crystalline silicon i-layer exhibit a strong correlation with the crystallinity of the crystalline silicon i-layer. In the above invention, the substrate in-plane crystallinity is preferably controlled by adjusting at least one of the silane partial pressure and the high-frequency electric power density during deposition of the crystalline silicon i-layer.

In the present invention, by ensuring that the Raman peak ratio in the majority of regions within the substrate plane of the crystalline silicon i-layer is within a range from not less than 3.5 to not more than 8.0, and ensuring that the surface area proportion within the substrate plane of high-brightness reflective regions having a Raman peak ratio of 2.5 or less is not more than 3%, the output of the photovoltaic device having a large surface area substrate can be increased, and problems caused by detachment of the photovoltaic layer can be prevented. Further, by controlling the deposition conditions and depositing the crystalline silicon i-layer such that the Raman peak ratio for the crystalline silicon i-layer and the surface area proportion within the substrate plane of high-brightness reflective regions satisfy the respective ranges described above, a high-output photovoltaic device can be produced with good stability.

### Brief Description of Drawings

[FIG. 1] A schematic illustration representing the structure of an embodiment of a photovoltaic device according to the present invention.
[FIG. 2] A schematic illustration describing an embodiment for producing a solar cell panel using a process for producing a photovoltaic device according to the present invention.
[FIG. 3] A schematic illustration describing an embodiment for producing a solar cell panel using a process for producing a photovoltaic device according to the present invention.
[FIG. 4] A schematic illustration describing an embodiment for producing a solar cell panel using a process for producing a photovoltaic device according to the present invention.
[FIG. 5] A schematic illustration describing an embodiment for producing a solar cell panel using a process for producing a photovoltaic device according to the present invention.
[FIG. 6] A graph illustrating the relationship between the Raman peak ratio of the crystalline silicon i-layer within a small-surface area cell and the cell open-circuit voltage.
[FIG. 7] A graph illustrating the relationship between the Raman peak ratio of the crystalline silicon i-layer within a small-surface area cell and the conversion efficiency.
[FIG. 8] A partial perspective view illustrating a portion of the structure of a thin-film production apparatus that uses the process for producing a photovoltaic device according to an embodiment of the present invention.
[FIG. 9] A diagram illustrating the solar cell unit cell voltage when the high-frequency electric power density and the SiH₄ partial pressure are changed.
[FIG. 10] A graph illustrating the relationship between the surface area of high-brightness reflective regions within the crystalline silicon i-layer and the solar cell module output.
[FIG. 11] A graph illustrating the relationship between the high-frequency electric power density applied to eight discharge electrodes and the performance of the solar cell panel.
[FIG. 12] A graph illustrating the relationship between the high-frequency electric power density per electrode and the surface area proportion of high-brightness reflective regions.
[FIG. 13] A graph illustrating the distribution of the high-frequency electric power density across each of the discharge electrodes.
[FIG. 14] A graph illustrating the relationship between the surface area proportion of high-brightness reflective regions and the performance of the solar cell panel.

### Explanation of Reference:

- 1:: Substrate
- 2:: Transparent electrode layer
- 3:: Photovoltaic layer
- 4:: Back electrode layer
- 5:: Intermediate contact layer
- 6:: Solar cell module
- 31:: Amorphous silicon p-layer
- 32:: Amorphous silicon i-layer
- 33:: Amorphous silicon n-layer
- 41:: Crystalline silicon p-layer
- 42:: Crystalline silicon i-layer
- 43:: Crystalline silicon n-layer
- 91:: First cell layer
- 92:: Second cell layer
- 100:: Photovoltaic device
- 103a to 103h:: Discharge electrode
- 113at, 113ht, 113ab, 113hb:: Matching unit
- 112a, 114a, 112b, 114b:: High-frequency feed transmission line
- 115a, 115b:: Heating medium supply line
- 116a, 116b:: Raw material gas line
- 153, 154:: Feeding point

### Best Mode for Carrying Out the Invention

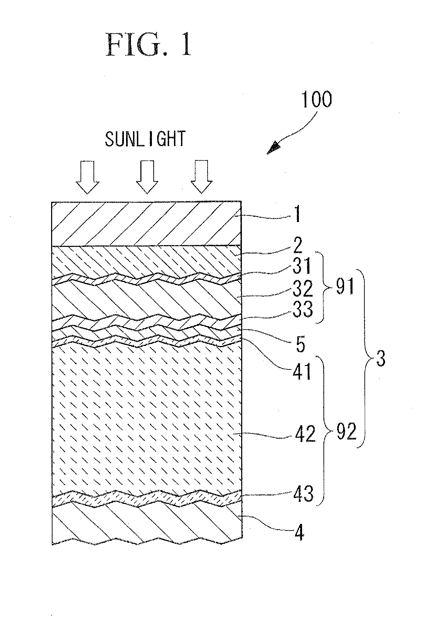

FIG. 1 is a schematic view illustrating the structure of an embodiment of a photovoltaic device according to the present invention. A photovoltaic device 100 is a tandem-type silicon-based solar cell, and comprises a substrate 1, a transparent electrode layer 2, a first cell layer 91 (an amorphous silicon series) and a second cell layer 92 (a crystalline silicon series) that function as a photovoltaic layer 3, an intermediate contact layer 5, and a back electrode layer 4. Here, the terms "silicon-based" and "silicon series" are generic terms that include silicon (Si), silicon carbide (SiC) and silicon germanium (SiGe). Further, a crystalline silicon series describes a silicon series other than an amorphous silicon series, and includes both microcrystalline silicon and polycrystalline silicon.

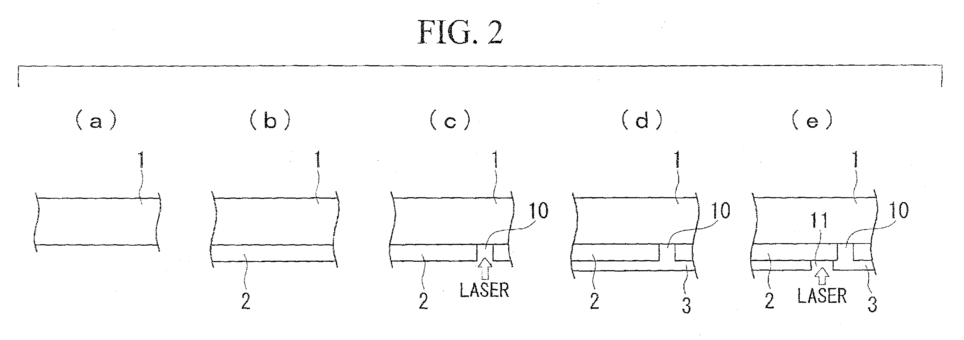

A process for producing the photovoltaic device according to the present embodiment is described below, using the steps for producing a solar cell panel as an example. FIG. 2 to FIG. 5 are schematic illustrations illustrating the process for producing a solar cell panel according to the present embodiment.

### (1) FIG. 2(a):

A soda float glass substrate (for example, 1.4 m × 1.1 m × thickness: 3.5 to 4.5 mm) is used as the substrate 1. The edges of the substrate are preferably subjected to corner chamfering or R-face chamfering to prevent damage caused by thermal stress or impacts or the like.

### (2) FIG. 2(b):

A transparent electrode film comprising mainly tin oxide (SnO₂) and having a film thickness of approximately not less than 500 nm and not more than 800 nm is deposited as the transparent electrode layer 2 using a thermal CVD apparatus at a temperature of approximately 500°C. During this deposition, a texture comprising suitable asperity is formed on the surface of the transparent electrode film. In addition to the transparent electrode film, the transparent electrode layer 2 may include an alkali barrier film (not shown in the figure) formed between the substrate 1 and the transparent electrode film. The alkali barrier film is formed using a thermal CVD apparatus at a temperature of approximately 500°C to deposit a silicon oxide film (SiO₂) having a film thickness of 50 nm to 150 nm.

### (3) FIG. 2(c):

Subsequently, the substrate 1 is mounted on an X-Y table, and the first harmonic of a YAG laser (1064 nm) is irradiated onto the surface of the transparent electrode film, as shown by the arrow in the figure. The laser power is adjusted to ensure an appropriate process speed, and the substrate 1 and the laser light are moved relative to each other so that the transparent electrode film is moved in a direction perpendicular to the direction of the series connection of the electric power generation cells, thereby performing laser etching across a strip having a predetermined width of approximately 6 mm to 15 mm to form a slot 10.

### (4) FIG. 2(d):

Using a plasma-enhanced CVD apparatus, a p-layer, an i-layer and an n-layer, each composed of a thin film of amorphous silicon, are deposited as the first cell layer 91. Using SiH₄ gas and H₂ gas as the main raw materials, and under conditions including a reduced pressure atmosphere of not less than 30 Pa and not more than 1,000 Pa and a substrate temperature of approximately 200°C, an amorphous silicon p-layer 31, an amorphous silicon i-layer 32 and an amorphous silicon n-layer 33 are deposited, in that order, on the transparent electrode layer 2, with the p-layer closest to the surface from which incident sunlight enters. The amorphous silicon p-layer 31 comprises mainly amorphous B-doped silicon, and has a thickness of not less than 10 nm and not more than 30 nm. The amorphous silicon i-layer 32 has a thickness of not less than 200 nm and not more than 350 nm. The amorphous silicon n-layer 33 comprises mainly P-doped silicon containing microcrystalline silicon within an amorphous silicon, and has a thickness of not less than 30 nm and not more than 50 nm. A buffer layer may be provided between the amorphous silicon p-layer 31 and the amorphous silicon i-layer 32 in order to improve the interface properties.

An intermediate contact layer 5 that functions as a semi-reflective film for improving the contact properties and achieving electrical current consistency is provided between the first cell layer 91 and the second cell layer 92. A GZO (Ga-doped ZnO) film with a thickness of not less than 20 nm and not more than 100 nm is deposited as the intermediate contact layer 5 using a sputtering apparatus with a Ga-doped ZnO sintered body as the target. In some cases the contact layer 5 is not provided.

Next, using a plasma-enhanced CVD apparatus and under conditions including a reduced pressure atmosphere of not more than 3,000 Pa, a substrate temperature of approximately 200°C and a plasma generation frequency of not less than 40 MHz and not more than 100 MHz, a crystalline silicon p-layer 41, a crystalline silicon i-layer 42 and a crystalline silicon n-layer 43 are deposited, in that order, as the second cell layer 92, on top of either the first cell layer 91 or the intermediate contact layer 5. The crystalline silicon p-layer 41 comprises mainly B-doped microcrystalline silicon, and has a thickness of not less than 10 nm and not more than 50 nm. The crystalline silicon i-layer 42 comprises mainly microcrystalline silicon, and has a thickness of not less than 1.2 µm and not more than 3.0 µm. The crystalline silicon n-layer 43 comprises mainly P-doped microcrystalline silicon, and has a thickness of not less than 20 nm and not more than 50 nm.

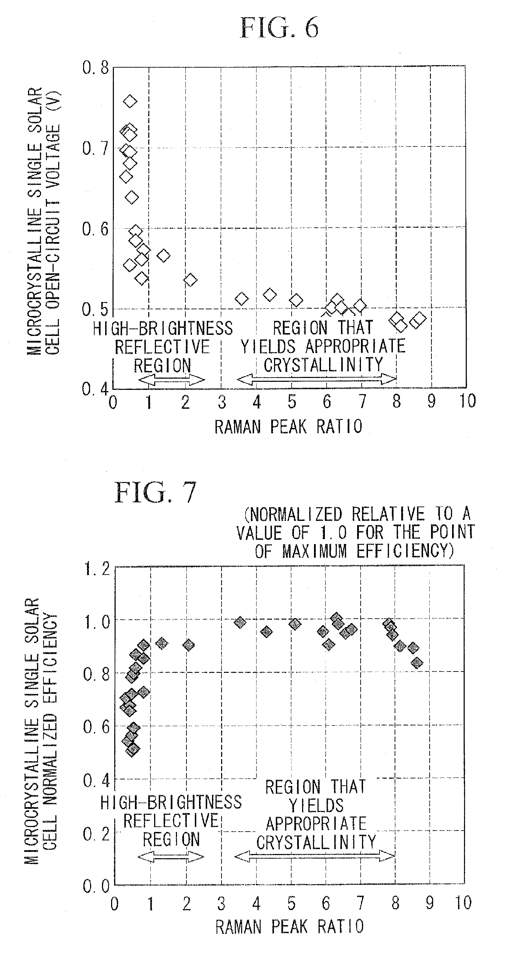

An evaluation substrate is prepared by depositing only the above second cell layer 92 on a large surface area substrate, namely by sequentially depositing the transparent electrode layer 2, the crystalline silicon p-layer 41, the crystalline silicon i-layer 42 and the crystalline silicon n-layer 43 on the substrate, and then depositing the back electrode layer 4. The results obtained upon dividing this substrate into small surface area cells of not more than 1 cm² and then evaluating the open-circuit voltage of each cell are illustrated in FIG. 6. In this figure, the horizontal axis represents the Raman peak ratio, and the vertical axis represents the open-circuit voltage. Further, the results of evaluating the conversion efficiency and normalizing the results relative to the maximum efficiency are illustrated in FIG. 7. In this figure, the horizontal axis represents the Raman peak ratio, and the vertical axis represents the conversion efficiency (normalized relative to the maximum efficiency). The values for the Raman peak ratio illustrated along the horizontal axis represent values for the various evaluation substrates, in which deposition was performed for the same time and under the same deposition conditions up until the individual crystalline silicon i-layers 42.
In FIG. 6, the open-circuit voltage increases when the Raman peak ratio evaluation for the small surface area cell falls to 2.5 or less, but high-brightness reflective regions occur. In FIG. 7, when the Raman peak ratio evaluation for the small surface area cell falls to 2.5 or less, a decrease in the short-circuit current causes the conversion efficiency to begin to decrease markedly, and the conversion efficiency is reduced significantly for Raman peak ratios of 1 or less. From the results in FIG. 7 it is evident that the lower limit for the Raman peak ratio in order to achieve a high conversion efficiency is 2.5 or greater, and a ratio of 3.5 or greater is preferable. The upper limit for the Raman peak ratio is not more than 8.0. If the Raman peak ratio exceeds 8.0, then a decrease in the open-circuit voltage causes a reduction in the conversion efficiency. A Raman peak ratio of 7.0 or less yields minimal decrease in the open-circuit voltage and is consequently preferred.
Accordingly, the Raman peak ratio value that represents the condition for achieving a high conversion efficiency for a small surface area cell is preferably within a range from not less than 2.5 to not more than 8.0. The Raman peak ratio value is more preferably within a range from not less than 3.5 and not more than 8.0, and is most preferably not less than 3.5 and not more than 7.0.

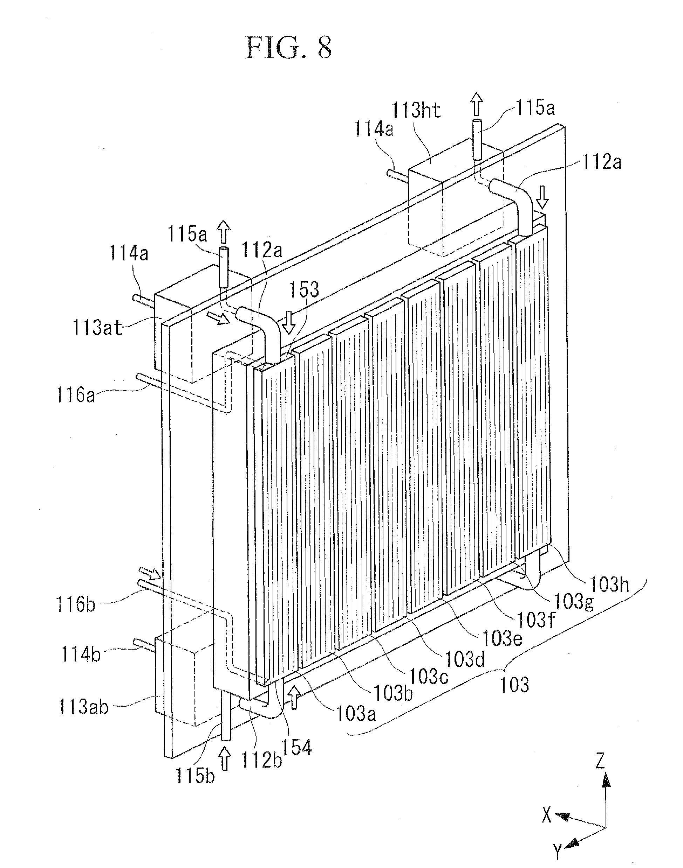

In the present embodiment that uses a large surface area substrate of not less than 1 m², the crystalline silicon i-layer 42 comprises regions in which the average value of the Raman peak ratio within the substrate plane is within a range from not less then 3.5 to not more than 8.0.
In the Raman peak ratio within the substrate plane, a distribution occurs to some extent. For example, a discharge electrode 103 illustrated in FIG. 8 has a structure in which a raw material gas is supplied from a plurality of blow holes provided in the discharge electrode, and the unreacted raw material gas is discharged between each of the discharge electrodes (rod-shaped vertical electrodes). As a result, the raw material gas flows towards the discharge portion while being consumed by deposition in the vicinity of the substrate surface, and this causes localized distributions to develop in the raw material gas concentration, meaning a distribution also develops in the Raman peak ratio. The surface area proportion of these types of localized regions may reach approximately 10% in some cases. In particular, a distribution in the raw material gas concentration tends to cause scattered regions having high Raman peak ratio values. Further, a distribution in the Raman peak ratio may also occur due to distributions in the deposition conditions (such as the substrate temperature, the raw material gas, and the electric power density supplied to the discharge electrode) across the large surface area substrate.
Accordingly, in the present embodiment, the surface area proportion of those regions for which the Raman peak ratio is within a range from not less then 3.5 to not more than 8.0 is not less than 80%, preferably not less than 90%, and still more preferably 95% or greater. In such cases, the possibility of regions for which the Raman peak ratio exceeds 8.0 being concentrated in a small area is minimal, and provided the surface area proportion of those regions for which the Raman peak ratio satisfies the predetermined range is not less than 80%, the effect on the performance of the overall solar cell module is minimal. In contrast, if the surface area proportion of those regions for which the Raman peak ratio is within a range from not less then 3.5 to not more than 8.0 is less than 80%, the possibility of regions for which the Raman peak ratio exceeds 8.0 being concentrated in a small area increases, which can effect the performance of the solar cell module. For this reason, when adjusting the deposition conditions for a large surface area substrate, the adjustment is preferably performed to achieve a low crystallinity prior to the point at which high-brightness reflective regions occur.
Furthermore, in the crystalline silicon i-layer 42 of the present embodiment, if the proportion of those regions for which the Raman peak ratio within the substrate plane is 2.5 or less (high-brightness reflective regions) increases, then the module output decreases. For that reason, the surface area proportion of the high-brightness reflective regions is restricted to not more than 3%.

During formation of the i-layer film comprising mainly microcrystalline silicon using a plasma-enhanced CVD method, a distance d between the plasma discharge electrode and the surface of the substrate 1 is preferably not less than 3 mm and not more than 10 mm. If this distance d is less than 3 mm, then the precision of the various structural components within the deposition chamber required for processing large substrates means that maintaining the distance d at a constant value becomes difficult, which increases the possibility of the electrode getting too close and making the discharge unstable. If the distance d exceeds 10 mm, then achieving a satisfactory deposition rate (of at least 1 nm/s) becomes difficult, and the uniformity of the plasma also deteriorates, causing a deterioration in the quality of the film due to ion impact.

In a deposition apparatus for large surface area substrates, a plurality of discharge electrodes are usually provided. FIG. 8 is a partial perspective view illustrating a portion of the structure of a thin-film production apparatus (plasma-enhanced CVD apparatus) that uses the process for producing a photovoltaic device according to the present invention. The XYZ directions are indicated by arrows in the figure. In this embodiment, the discharge electrode 103 comprises, for example, eight discharge electrodes 103a to 103h, wherein each electrode comprises two horizontal electrodes that extend in a substantially parallel arrangement along the Y-direction, and a plurality of rod-shaped vertical electrodes that are provided between the two horizontal electrodes and extend in a substantially parallel arrangement along the Z-direction. For each of the discharge electrodes 103a to 103h, a matching unit 113at to 113ht respectively, high-frequency feed lines 112a and 114a, a heating medium supply line 115a and a raw material gas line 116a are provided at a feed point 153. Further, a matching unit 113ab to 113hb respectively, high-frequency feed lines 112b and 114b, a heating medium supply line 115b and a raw material gas line 116b are provided at a feed point 154. In FIG. 8, in order to simplify the drawing, only the matching units 113at, 113ab and 113ht are shown, whereas the other matching units are omitted. A high-frequency electric power is supplied to the feed points 153 of the discharge electrodes 103a to 103h from a high-frequency power source (not shown in the figure), while high-frequency electric power is supplied to the feed points 154 from a separate high-frequency power source (also not shown in the figure).

The crystalline silicon i-layer 42 is deposited so that the Raman peak ratio satisfies the predetermined range described above, for example, using the process described below.
The Raman peak ratio of the crystalline silicon i-layer 42 is measured following deposition of the crystalline silicon i-layer 42, by irradiating, for example, a frequency-doubled YAG laser light (wavelength: 532 nm) as a monochromatic laser onto the surface of the i-layer, and is represented by the ratio, within the Raman spectrum, of the peak intensity Ic of the crystalline silicon phase (the peak intensity near a frequency of 520 cm⁻¹) relative to the peak intensity Ia of the amorphous silicon phase (the peak intensity near a frequency of 480 cm⁻¹) (namely, the Raman peak ratio Ic/Ia). In order to evaluate the crystallinity of the actual photovoltaic layer (crystalline silicon i-layer), those layers of the second cell layer 92 up to and including the crystalline silicon p-layer 41 and the crystalline silicon i-layer 42 are preferably deposited on top of the first cell layer 91 or the intermediate contact layer 5, and the Raman spectrum is then measured.
The high-brightness reflective regions are calculated by image observation using a CCD camera, either immediately following deposition of the crystalline silicon i-layer 42, or following completion of deposition up to and including the second cell layer 92. The crystalline silicon n-layer 43 of the second cell layer 92 is a thin layer with a thickness of approximately 20 to 50 nm, and therefore the reflective state of the surface of the crystalline silicon i-layer 42 can still be determined even following completion of the deposition of the second cell layer 92. For this reason, evaluation of the high-brightness reflective regions is usually performed using substrates in which deposition has been completed up to and including the second cell layer 92. Using a CCD camera, the CCD camera is moved relative to the substrate transported out of the plasma-enhanced CVD apparatus, and an RGB two-dimensional image is captured of the surface of the crystalline silicon i-layer or second cell layer on top of the large surface area substrate. The smallest area of the substrate detected by the CCD camera image observation is set, for example, to 8 mm × 8 mm. The RGB two-dimensional image captured by the CCD camera is transmitted to a computer as a color image signal. The computer converts the signal to the CIE-XYZ color system, and then to the CIE-L*a*b color system. These conversions can be performed easily using conventional techniques. In this manner, the L* value (brightness) within the two-dimensional image is determined. Because a correlation exists between the crystallinity (Raman peak ratio) of the crystalline silicon i-layer and the L* value (brightness), the computer compares the L* value at each pixel acquired by the camera with a preset threshold, and identifies those regions that exceed the threshold as high-brightness reflective regions. Subsequently, the computer calculates the surface area of the regions identified as high-brightness reflective regions and the total surface area of the two-dimensional image, and then calculates the surface area proportion of the high-brightness reflective regions relative to the total surface area of the two-dimensional image.

The threshold for the L* value is set using the process outlined below, by utilizing the correlation between the crystallinity of the crystalline silicon i-layer and the L* value. A plurality of samples are prepared by performing deposition on a substrate, either up to and including the crystalline silicon i-layer or until completion of the deposition of the second cell layer, with each sample having a photovoltaic layer with a known Raman peak ratio and a structure and thickness that are substantially the same as the layer being evaluated. Each sample has a different Raman peak ratio for the crystalline silicon i-layer. Subsequently, using the CCD camera mentioned above, an RGB two-dimensional image is captured of the crystalline silicon i-layer of each sample, and the image processing described above is used to ascertain the L* value for each sample. A brightness function that correlates the acquired L* value for each of the sample with the corresponding Raman peak ratio is then created. For example, the results for each sample are plotted on a graph with the Raman peak ratio along the horizontal axis and the L* value along the vertical axis to create a brightness function. In this embodiment, the L* value in the created brightness function where the Raman peak ratio reaches 2.5 is set as the L* threshold.

The computer determines whether or not the calculated surface area proportion of the high-brightness reflective regions relative to the total substrate surface area is 3% or less. If this proportion is 3% or less, then deposition of the crystalline silicon i-layer and production of the solar cell are continued without adjusting the deposition conditions.

If the calculated surface area proportion of the high-brightness reflective regions is greater than 3%, then the amount of reflected power from the high-frequency electric power supplied to each of the discharge electrodes 103a to 103h is measured. Measurement of the reflected power can be performed using any appropriate conventional method. If the measured amount of reflected power is greater than a reference value, then the high-frequency circuit used for plasma generation is checked for abnormalities. If an abnormality is discovered, then deposition of the crystalline silicon i-layer is stopped, and the operator undertakes appropriate repair or adjustment of the apparatus. If no abnormalities are found, then the computer determines the distribution of the high-brightness reflective regions across the substrate, and identifies any areas of concentration of the high-brightness reflective regions. The measurement and determination of the amount of reflected power from the high-frequency electric power may be omitted.

The computer displays the surface area proportion of the high-brightness reflective regions and the state of the distribution of those high-brightness reflective regions. The operator may then adjust the deposition conditions for the crystalline silicon i-layer on the basis of this information.

As the high-frequency electric power density increases, the Raman peak ratio of the crystalline silicon i-layer also increases. Further, as the SiH₄ partial pressure decreases, the Raman peak ratio of the crystalline silicon i-layer increases and the deposition rate of the crystalline silicon i-layer tends to decrease. If high-brightness reflective regions have occurred across the entire substrate, then the operator either increases the density of the high-frequency electric power supplied to the discharge electrode, or reduces the SiH₄ partial pressure. The high-frequency electric power density and the SiH₄ partial pressure may also be adjusted in a matrix-like manner.
The appropriate ranges for the high-frequency electric power density and SiH₄ partial pressure for achieving a Raman peak ratio for the crystalline silicon i-layer of not less than 3.5 and not more than 8.0 are acquired in advance. Similarly, the SiH₄ partial pressure range that yields a deposition rate which enables a favorable level of productivity to be maintained is also determined in advance. In those cases where the computer determines that the high-brightness reflective regions are dispersed across the entire substrate, the operator alters the deposition conditions for the crystalline silicon i-layer within the acquired appropriate ranges for the high-frequency electric power density and the SiH₄ partial pressure. Using the process described above, the computer then determines the surface area proportion of the high-brightness reflective regions for the second cell layer (or crystalline silicon i-layer) deposited following the alterations to the deposition conditions. This process of altering the deposition conditions and determining the surface area proportion of the high-brightness reflective regions is then repeated until the surface area proportion of the high-brightness reflective regions in the second cell layer (or crystalline silicon i-layer) deposited under the altered deposition conditions falls to not more than 3%. Once the surface area proportion of the high-brightness reflective regions has fallen to not more than 3%, adjustment of the deposition conditions is halted, and production of the solar cell is continued using the last adjusted deposition conditions for the crystalline silicon i-layer.

In those cases where the high-frequency electric power density is increased in order to suppress the occurrence of high-brightness reflective regions, because the matching balance for the matching units upon supply of the high-frequency electric power changes, the plasma strength distribution along the vertical direction of each of the discharge electrodes 103a to 103h also changes, which increases the possibility of localized high-brightness reflective regions being generated. If the computer determines that localized high-brightness reflective regions are occurring, then the operator adjusts the matching balance, for example by adjusting the variable capacitor of the matching unit within the transmission line that supplies the high-frequency electric power to each discharge electrode, and adjusts the high-frequency electric power density supplied to each discharge electrode. For example, the high-frequency electric power density is increased for the discharge electrode(s) that corresponds with the position(s) where the high-brightness reflective regions have occurred. This process of altering the high-frequency electric power density and adjusting the matching balance and then determining the surface area proportion of the high-brightness reflective regions in the deposited second cell layer (or crystalline silicon i-layer) is then repeated until the surface area proportion of the high-brightness reflective regions in the second cell layer (or crystalline silicon i-layer) deposited under the altered deposition conditions falls to not more than 3%. Once the surface area proportion of the high-brightness reflective regions has fallen to not more than 3%, adjustment of the deposition conditions is halted, and production of the solar cell is continued using the last adjusted deposition conditions for the crystalline silicon i-layer.

By employing the process described above to increase the proportion of regions having a film quality prior to the occurrence of a high-brightness reflective region, the distribution of the crystallinity of the crystalline silicon i-layer can be controlled so that those regions having a Raman peak ratio of not less than 3.5 and not more than 8.0 represent 80% or more of the substrate surface area, and the surface area proportion of high-brightness reflective regions having a Raman peak ratio of 2.5 or less is 3% or less.

In a separate embodiment, adjustment of the deposition conditions can be performed using the cell voltage (open-circuit voltage) of the solar cell unit cells, so that the surface area proportion of high-brightness reflective regions is restricted to not more than 3%.
The photovoltaic layer formed on the substrate is partitioned into strip-like cells having a predetermined width using laser scribing or the like, and these cells are then integrated by connection in series. In those cases where the vertical direction of the discharge electrode (the Z-direction in FIG. 8) and the direction of the cells formed on the substrate are orthogonal, the cell voltage corresponding with the vertical direction of the discharge electrode (the Z-direction) is measured for those solar cell unit cells in the vicinity of the regions that have been identified as having a surface area proportion of high-brightness reflective regions that exceeds 3%. Measurement of the open-circuit voltage is performed by measuring the voltage between a current collection cell that is connected electrically to the transparent electrode layer at the substrate edge, and the back electrode layer of the target cell. This measurement can be performed using a conventional method.

As the high-frequency electric power density is increased and the SiH₄ partial pressure is reduced, the crystallinity (Raman peak ratio) tends to increase and the cell voltage tends to decrease. In the present embodiment, the cell voltage range that yields a Raman peak ratio for the crystalline silicon i-layer that is not less than 3.5 and not more than 8.0, and the SiH₄ partial pressure range that yields a deposition rate for the crystalline silicon i-layer which enables a favorable level of productivity to be maintained are determined in advance. In those cases where the computer determines that the cell voltage is less than a predetermined value across the entire substrate, the operator alters the high-frequency electric power density or the SiH₄ partial pressure, within the SiH₄ partial pressure range that enables a favorable level of productivity to be obtained, until a predetermined cell voltage that yields a Raman peak ratio for the crystalline silicon i-layer of not less than 3.5 and not more than 8.0 is achieved. At this time, the high-frequency electric power density and the SiH₄ partial pressure may also be altered in a matrix-like manner. The crystallinity (Raman peak ratio) of the crystalline silicon i-layer formed on the large surface area substrate is adjusted so that the cell voltage approaches a level that yields a high output, and is equivalent to a low crystallinity just prior to the occurrence of high-brightness reflective regions. Once a predetermined cell voltage is achieved, the operator halts the adjustment of the deposition conditions, and production of the solar cell is continued using the last adjusted deposition conditions for the crystalline silicon i-layer.

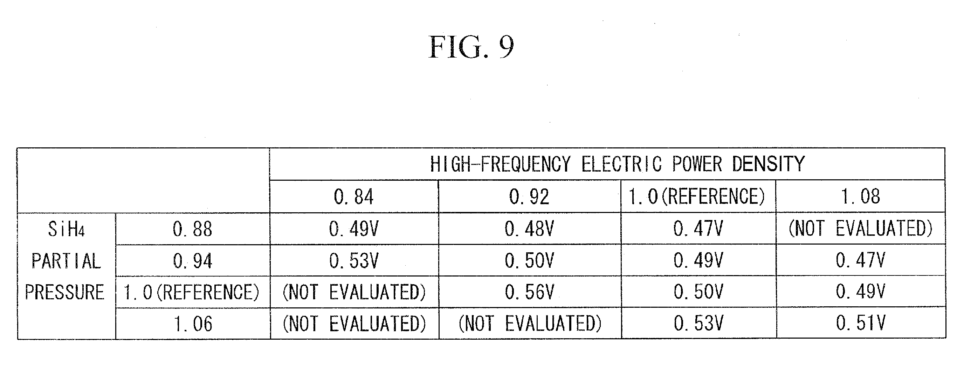

FIG. 9 is an example illustrating the solar cell unit cell voltage when the high-frequency electric power density and the SiH₄ partial pressure are varied in a matrix-like manner. The conditions under which crystalline silicon solar cell unit cells were obtained with a fill factor F.F. of >0.7 and a high conversion efficiency (of approximately 8%) were specified as reference values (1.0) for the high-frequency electric power density and the SiH₄ partial pressure. In the example illustrated in FIG. 9, the cell voltage at the reference values was 0.5 V, and for those combinations of the high-frequency electric power density and the SiH₄ partial pressure that yielded a cell voltage exceeding 0.5 V, it is thought that formation of a film having a Raman peak ratio of ≤ (approximately 2.5) caused the occurrence of high-brightness reflective regions across a surface area proportion exceeding 3% of the substrate surface area. In those cases where the cell voltage is lower than 0.5 V, although high-brightness reflective regions do not occur, it is thought that a film having a Raman peak ratio exceeding 8.0 is formed, causing a reduction in the conversion efficiency. Accordingly, in this example, in order to achieve a cell voltage that yields a high output and is equivalent to a low crystallinity just prior to the generation of high-brightness reflective regions, the high-frequency electric power density and the SiH₄ partial pressure are adjusted so as to achieve a cell voltage of not less than 0.49 V and not more than 0.51 V.

As described above, when the high-frequency electric power density is increased to suppress the occurrence of high-brightness reflective regions, because the matching balance for the matching units upon supply of the high-frequency electric power changes, the plasma strength distribution along the vertical direction of each of the discharge electrodes 103a to 103h also changes, which increases the possibility of localized high-brightness reflective regions being generated. In the case of deposition processing in which the vertical direction of the discharge electrode (the Z-direction) and the direction of the cells formed on the substrate are orthogonal, the photovoltaic cells formed on the substrate are aligned along the lengthwise direction of the electrode rods (the vertical direction or Z-direction in FIG. 8). If the matching balance changes, and the plasma strength distribution along the vertical direction of each of the discharge electrodes 103a to 103h changes, then the cell voltage distribution of the photovoltaic cells corresponding with the vertical direction (Z-direction) also changes.
In this embodiment, the computer creates a substrate in-plane distribution chart of the measured cell voltages. If regions in which the cell voltage is lower than a predetermined value occur in a localized area, then the operator adjusts the matching balance using the matching unit of each discharge electrode, and adjusts the high-frequency electric power density supplied to each of the discharge electrodes, so that the cell voltage corresponding with the vertical direction of the discharge electrodes is aligned with the predetermined value. For example, in the example shown in FIG. 9, the matching balance of the matching units and the high-frequency electric power density supplied to the discharge electrodes are adjusted so that the cell voltage along the vertical direction (Z-direction) is within a range from not less than 0.49 V to not more than 0.51 V. Once the predetermined cell voltage has been achieved, adjustment of the deposition conditions is halted, and production of the solar cell is continued using the last adjusted deposition conditions for the crystalline silicon i-layer.

In the case of deposition processing in which the vertical direction of the discharge electrode (the Z-direction) and the cell direction of the solar cell unit cells formed on the substrate are substantially parallel, the solar cell unit cell voltage distribution along the vertical direction of the discharge electrode can not be evaluated. In this case, if the computer determines that the surface area proportion of high-brightness reflective regions is greater than 3%, then a deposition conditions evaluation substrate is introduced into the crystalline silicon i-layer deposition apparatus. This deposition conditions evaluation substrate is a substrate on which is formed a transparent electrode layer having substantially the same thickness as that of the product, which has not been subjected to the laser etching illustrated in FIG. 2(c). Following deposition of the second cell layer, isolation slots are formed by laser etching an approximately 1 cm square lattice shape into the photovoltaic layer of the second cell layer and the back electrode layer, but without forming the isolation slots in the transparent electrode layer. This enables the cell open-circuit voltage to be measured on the lattice-shaped substrate. Using the deposition conditions evaluation substrate, in a similar manner to that described above, the operator repeats the process of adjusting the matching balance of the matching units, adjusting the high-frequency electric power density supplied to each of the discharge electrodes, and then determining the open-circuit voltage distribution following the adjustments, until the open-circuit voltage distribution for the cells following the adjustments adopts a uniform distribution centered around the target value. By using this process, the cell open-circuit voltage can be used to achieve a more uniform film quality, even when the cells are arranged substantially parallel to the lengthwise direction of the electrode rods of the discharge electrode.

In the embodiments described above, an operator performed the adjustments to the deposition conditions, but these adjustments may also be performed by a computer.

### (5) FIG. 2(e):

The substrate 1 is mounted on an X-Y table, and the second harmonic of a laser diode-excited YAG laser (532 nm) is irradiated onto the surface of the photovoltaic layer 3, as shown by the arrow in the figure. With the pulse oscillation set to 10 kHz to 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1, and in this case, because the high vapor pressure generated by the energy absorbed by the amorphous silicon-based first cell layer of the photovoltaic layer 3 can be utilized in etching the photovoltaic layer 3, more stable laser etching processing can be performed. The position of the laser etching line is determined with due consideration of positioning tolerances, so as not to overlap with the previously formed etching line.

### (6) FIG. 3(a):

Using a sputtering apparatus, an Ag film and a Ti film are deposited as the back electrode layer 4 under a reduced pressure atmosphere and at a deposition temperature of 150°C to 200°C. In this embodiment, an Ag film having a thickness of not less than 150 nm and not more than 500 nm, and a highly corrosion-resistant Ti film having a thickness of not less than 10 nm and not more than 20 nm which acts as a protective film for the Ag film are stacked in that order. Alternatively, the back electrode layer 4 may be formed as a stacked structure composed of a Ag film having a thickness of 25 nm to 100 nm, and an Al film having a thickness of 15 nm to 500 nm. In order to reduce the contact resistance between the crystalline silicon n-layer 43 and the back electrode layer 4 and improve the light reflectance, a GZO (Ga-doped ZnO) film with a film thickness of not less than 50 nm and not more than 100 nm may be formed between the photovoltaic layer 3 and the back electrode layer 4 using a sputtering apparatus.

### (7) FIG. 3(b):

The substrate 1 is mounted on an X-Y table, and the second harmonic of a laser diode excited YAG laser (532 nm) is irradiated through the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) FIG. 3 (c) and FIG. 4 (a) :

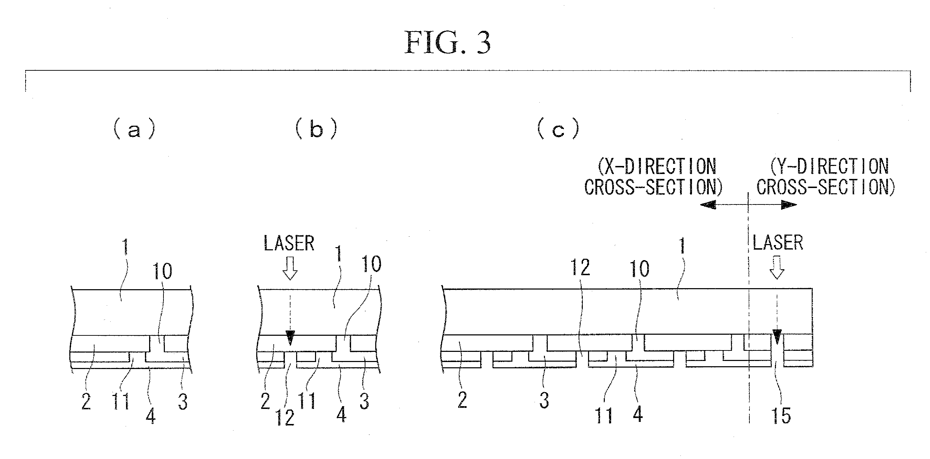

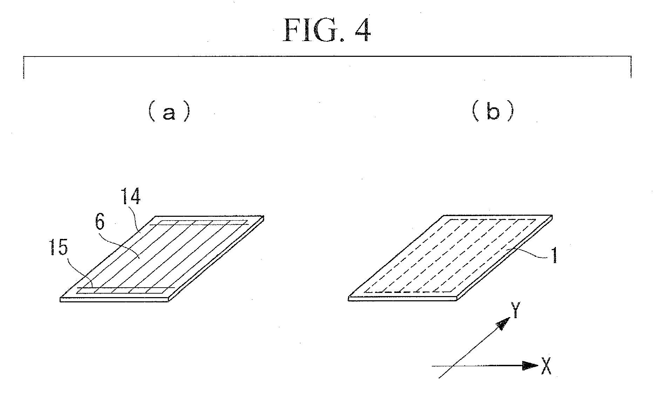

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated through the substrate 1. The laser light is absorbed by the transparent electrode layer 2 and the photovoltaic layer 3, and by utilizing the high gas vapor pressure generated at this point, the back electrode layer 4 is removed by explosive fracture, and the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). FIG. 3(c) represents an X-direction cross-sectional view cut along the direction of the series connection of the photovoltaic layer 3, and therefore the location in the figure where the insulation slot 15 is formed should actually appear as a peripheral film-removed region 14 in which the back electrode layer 4, the photovoltaic layer 3 and the transparent electrode layer 2 have been removed by film polishing (see FIG. 4(a)), but in order to facilitate description of the processing of the edges of the substrate 1, this location in the figure represents a Y-direction cross-sectional view, so that the formed insulation slot represents the X-direction insulation slot 15. A Y-direction insulation slot need not be provided at this point, because a film surface polishing and removal treatment is conducted on the peripheral film removal regions of the substrate 1 in a later step.

Completing the etching of the insulation slot 15 at a position 5 mm to 15 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YV04 laser or fiber laser or the like may also be used in a similar manner.

### (9) FIG. 4 (a: view from solar cell film surface, b: view from substrate side of light incident surface)

In order to ensure favorable adhesion and sealing of a backing sheet 24 via EVA or the like in a subsequent step, the stacked films around the periphery of the substrate 1 (in a peripheral film removal region 14), which tend to be uneven and prone to peeling, are removed to form a peripheral film-removed region 14. During removal of the films from a region that is 5 mm to 20 mm from the edge around the entire periphery of the substrate 1, grinding or blast polishing or the like is used to remove the back electrode layer 4, the photovoltaic layer 3 and the transparent electrode layer 2 from a region that is closer to the substrate edge in the X-direction than the insulation slot 15 provided in the above step of FIG. 3(c), and closer to the substrate edge in the Y-direction than the slot 10 provided near the substrate edge.
Grinding debris or abrasive grains are removed by washing the substrate 1.

### (10) FIG. 5 (a) (b):

An attachment portion for a terminal box 23 is prepared by providing an open through-window in the backing sheet 24 to expose a collecting plate. A plurality of layers of an insulating material are provided in this open through-window portion in order to prevent external moisture and the like entering the solar cell module.
Processing is conducted so as to enable current collection, using a copper foil, from the series aligned solar cell electric power generation cell at one end, and the solar cell electric power generation cell at the other end, in order to enable electric power to be extracted from the terminal box 23 on the rear surface of the solar cell panel. In order to prevent short circuits between the copper foil and the various portions, an insulating sheet that is wider than the width of the copper foil is provided.
Following arrangement of the collecting copper foil and the like at predetermined positions, the entire solar cell module 6 is covered with a sheet of an adhesive filling material such as EVA (ethylene-vinyl acetate copolymer), which is arranged so as not to protrude beyond the substrate 1.
A backing sheet 24 with a superior waterproofing effect is then positioned on top of the EVA. In this embodiment, in order to achieve a superior waterproofing and moisture-proofing effect, the backing sheet 24 is formed as a three-layer structure comprising a PET sheet, an Al foil and a PET sheet.
The structure comprising the components up to and including the backing sheet 24 arranged in predetermined positions is subjected to internal degassing under a reduced pressure atmosphere and under pressing at approximately 150°C to 160°C using a laminator, thereby causing cross-linking of the EVA that tightly seals the structure.

### (11) FIG. 5 (a) :

The terminal box 23 is attached to the back of the solar cell module 6 using an adhesive.

### (12) FIG. 5 (b) :

The copper foil and an output cable from the terminal box 23 are connected using solder or the like, and the interior of the terminal box 23 is filled and sealed with a sealant (a potting material). This completes the production of the solar cell panel 50.

### (13) FIG. 5(c):

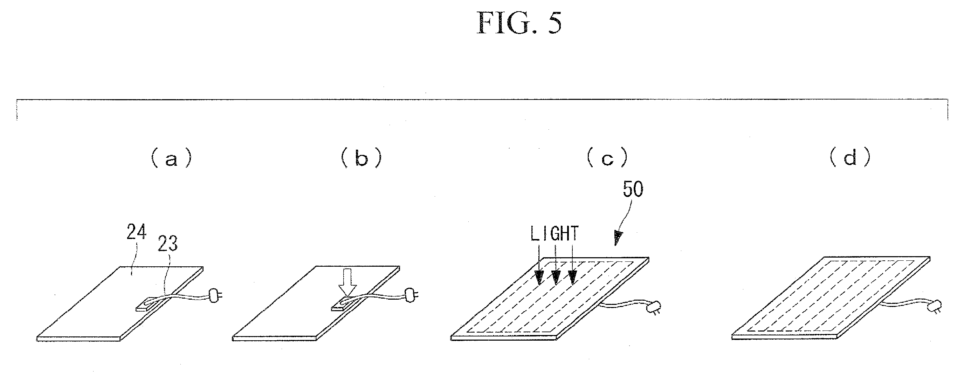

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).
Following attachment of the terminal box 23 illustrated in FIG. 5(a), the glass substrate surface of the solar cell panel 50 is preferably washed. Removing foreign matter (with a particle size of 0.1 to 10 µm) that is invisible to the naked eye from the substrate surface enables the electric power generation test of FIG. 5(c) and the other performance tests to be conducted more favorably.

### (14) FIG. 5(d)

In tandem with the electric power generation test (FIG. 5(c)), a variety of specific performance factors including the external appearance are evaluated.

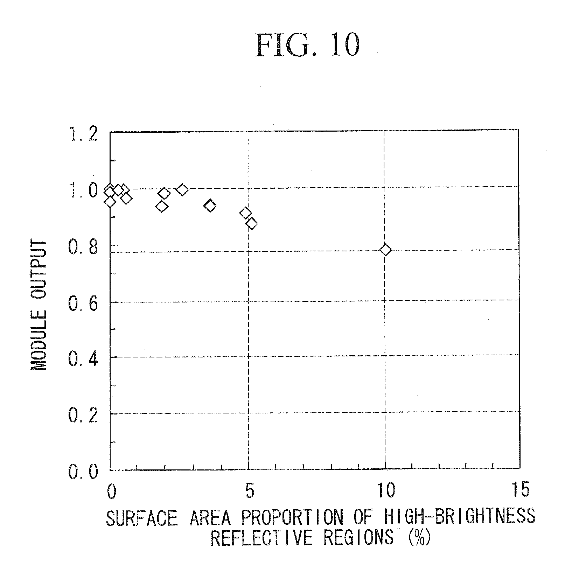

FIG. 10 illustrates the relationship between the surface area of high-brightness reflective regions within the crystalline silicon i-layer and the solar cell module output. The maximum output for the solar cell module is used as a reference value (1.0). In the figure, the horizontal axis represents the surface area proportion of high-brightness reflective regions within the crystalline silicon i-layer, and the vertical axis represents the module output normalized relative to the maximum output. As illustrated in FIG. 10, when the surface area proportion of the high-brightness reflective regions was 3% or less, a high output was able to be obtained in a stable manner. When the surface area proportion of the high-brightness reflective regions exceeded 3%, the short-circuit current in the low Raman peak ratio regions decreased, resulting in a reduced output.

### (Examples)

Using soda float glass substrates (1.4 m × 1.1 m × thickness: 3.5 to 4.5 mm), tandem-type solar cell modules illustrated in FIG. 1 were prepared. The composition and thickness of each of the layers was as listed below.
Transparent electrode layer: SnO₂, thickness: 500 to 800 nm.
First cell layer: amorphous silicon p-layer, amorphous silicon i-layer (thickness: 300 nm), amorphous silicon n-layer.
Intermediate contact layer: GZO, thickness: 50 to 100 nm.
Second cell layer: crystalline silicon p-layer, crystalline silicon i-layer (thickness: 2 µm), crystalline silicon n-layer.
Back electrode layer: GZO (thickness: 50 to 100 nm), Ag (thickness: 200 to 300 nm), Ti (thickness: 10 to 20 nm).

The crystalline silicon i-layer of the second cell layer was deposited using the eight-segment discharge electrode illustrated in FIG. 8. The deposition conditions included a hydrogen dilution ratio of H₂/SiH₄ ≥ 30, an SiH₄ partial pressure of 20 to 35 Pa, a total pressure of not more than 3,000 Pa, a substrate temperature of 200°C and a plasma generation frequency of 60 MHz, and this electric power was split and supplied to the eight segments of the discharge electrode, and a phase modulation method was used to achieve a uniform plasma. The amount of high-frequency electric power supplied to each of the discharge electrodes was altered in accordance with conditions #1 to #5, and the effects on the properties of the solar cell module were investigated. In the plasma-enhanced CVD apparatus used for depositing the crystalline silicon i-layer, the separation distance between the plasma discharge electrode and the substrate surface was 3 to 10 mm.

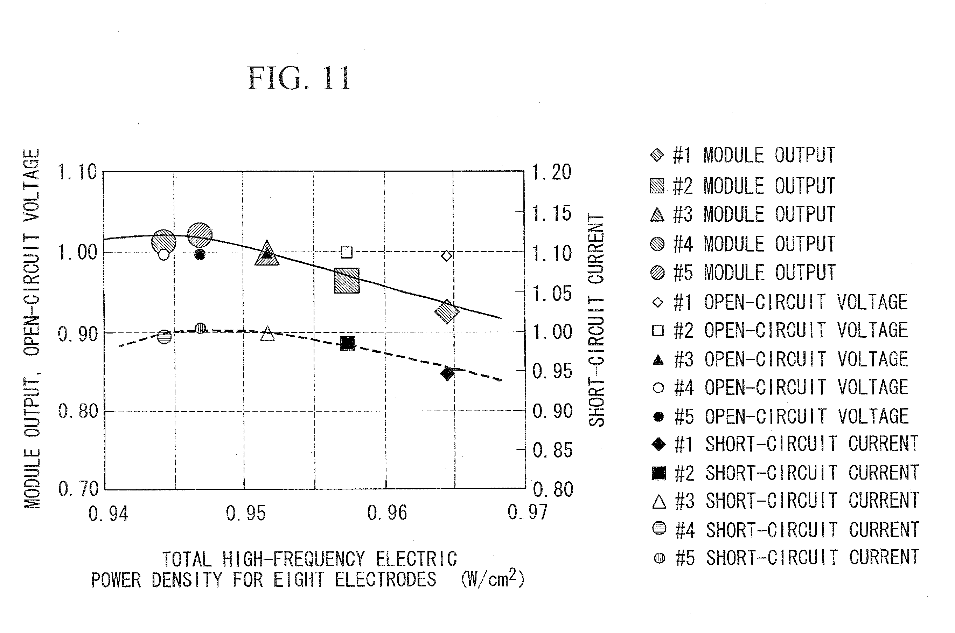

FIG. 11 is a graph illustrating the relationship between the high-frequency electric power density applied to the eight discharge electrodes and the performance of the solar cell panel. In this figure, the horizontal axis represents the total high-frequency electric power density, the left-hand vertical axis represents the maximum output and the open-circuit voltage of the solar cell module, and the right-hand vertical axis represents the short-circuit current. The maximum output, the open-circuit voltage and the short-circuit current were normalized relative to the maximum output, open-circuit voltage and short-circuit current respectively under the conditions #3.
For the thin film of the crystalline silicon i-layer, an ideal high-frequency electric power density range exists for increasing the short-circuit current, as a result of the relationship between the reduction in carrier loss caused by defects within the film and the reduction in the photoelectric current. From the results in FIG. 11 it is evident that for the conditions #1 and #2, the maximum output peak and the short-circuit current peak do not coincide. Accordingly, if the high-frequency electric power density is reduced to less than 0.94 W/cm², then it is anticipated that the output will deteriorate. For these reasons, it was thought that for this example, the most appropriate value for the high-frequency electric power density was from 0.94 to 0.95 W/cm².

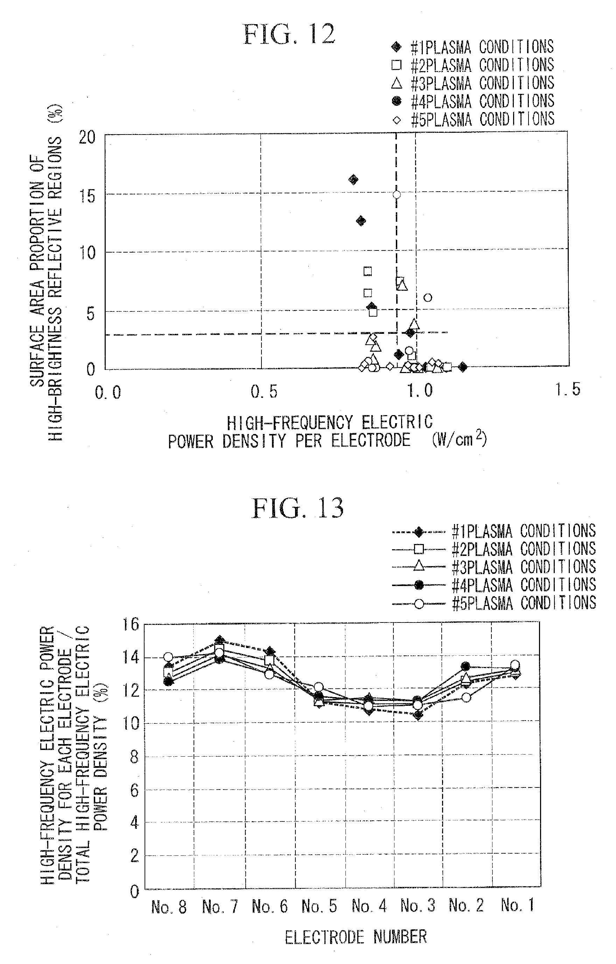

FIG. 12 is a graph illustrating the effect that the high-frequency electric power density per single discharge electrode exerts on the surface area proportion of high-brightness reflective regions. In this figure, the horizontal axis represents the high-frequency electric power density per electrode, and the vertical axis represents the surface area proportion of high-brightness reflective regions. As illustrated in FIG. 12, at each of the plasma conditions, a tendency was observed for the surface area proportion of high-brightness reflective regions to increase dramatically as the high-frequency electric power density was reduced. Based on these results, it was thought that ensuring a high-frequency electric power density per electrode of not less than 0.94 W/cm² would be effective in suppressing the occurrence of high-brightness reflective regions and restricting the surface area proportion of such regions to 3% or less.

The results illustrated in FIG. 11 and FIG. 12 suggest that, in this example, by suppressing the total high-frequency electric power density to a value within a range from 0.94 to 0.95 W/cm², while adjusting the high-frequency electric power density supplied to each of the electrodes, the crystallinity could be adjusted to a level of crystallinity prior to the occurrence of high-brightness reflective regions, thereby enabling a surface area proportion for the high-brightness reflective regions of not more than 3% to be achieved.

FIG. 13 illustrates the distribution of the high-frequency electric power density across each of the discharge electrodes. In this figure, the horizontal axis indicates the electrode number (equivalent to the electrodes 103a to 103h in FIG. 8), and the vertical axis represents the proportion of the high-frequency electric power density for each electrode relative to the total high-frequency electric power density. As a result of optimizing the high-frequency electric power density applied to each of the eight discharge electrodes in the manner shown in FIG. 13, the surface area proportion for high-brightness reflective regions under the plasma conditions #3, #4 and #5 was able to be suppressed to 2.0%, 2.6% and 0.5% respectively, each result being within the specified 3% limit. Because the underlying transparent electrode layer had been partitioned by laser etching into cell widths (approximately 10 mm), the high-brightness reflective regions occurred with a width of approximately 10 mm.

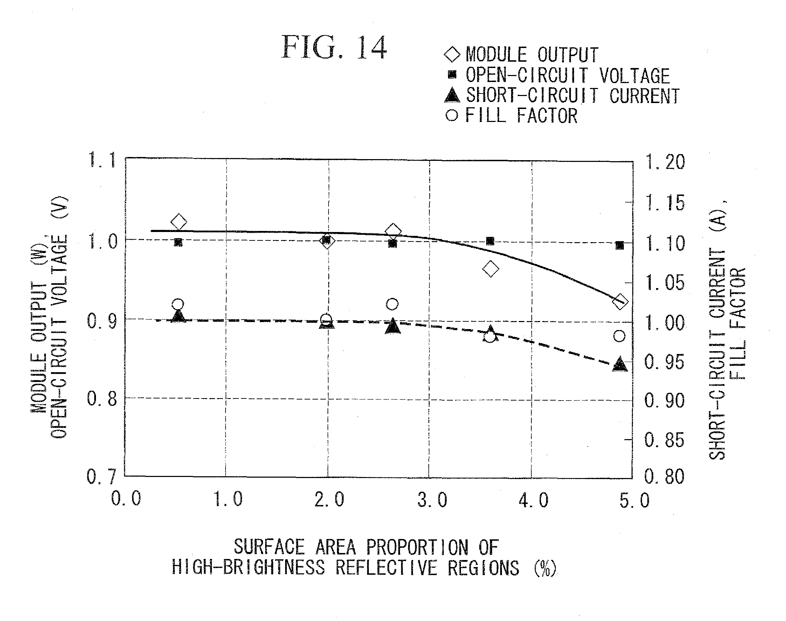

FIG. 14 is a graph illustrating the relationship between the surface area proportion of high-brightness reflective regions and the performance of the solar cell panel. In this figure, the horizontal axis represents the surface area proportion of high-brightness reflective regions, the left-hand vertical axis represents the maximum output and the open-circuit voltage of the solar cell panel, and the right-hand vertical axis represents the short-circuit current. The maximum output, the open-circuit voltage and the short-circuit current were normalized relative to the maximum output, open-circuit voltage and short-circuit current respectively under the conditions #3. As illustrated, as the surface area proportion of high-brightness reflective regions decreased, the short-circuit current, in particular, tended to increase, meaning the maximum output of the solar cell panel also increased.

Although the above embodiments were described using the example of a tandem solar cell comprising crystalline silicon layers as the photovoltaic layer, the present invention is not restricted to this example. For example, the invention can be similarly applied to crystalline silicon single solar cells, silicon-germanium solar cells, and triple solar cells comprising crystalline silicon layers and the like.
Furthermore, although a transparent substrate such as a glass substrate was used in the embodiments described above, the present invention may also be used with non-transparent substrates such as metal substrates.

## Claims

1. A photovoltaic device having a photovoltaic layer comprising a crystalline silicon i-layer formed on a large surface area substrate of not less than 1 m², wherein
the crystalline silicon i-layer comprises regions in which the average value of a Raman peak ratio, which is a ratio of a Raman peak intensity of a crystalline silicon phase relative to a Raman peak intensity of an amorphous silicon phase, is within a range from not less then 3.5 to not more than 8.0, and
a surface area proportion for those regions within the substrate plane having a Raman peak ratio of not more than 2.5 is not more than 3%.

2. The photovoltaic device according to claim 1, wherein a surface area proportion of regions within the substrate plane for which the Raman peak ratio is within a range from not less then 3.5 to not more than 8.0 is not less than 80%.

3. A process for producing a photovoltaic device having a photovoltaic layer comprising a crystalline silicon i-layer formed on a large surface area substrate of not less than 1 m², the process comprising:
depositing the crystalline silicon i-layer,
measuring a surface area proportion of those regions of the crystalline silicon i-layer for which a Raman peak ratio, which is a ratio of a peak intensity of a crystalline silicon phase relative to a peak intensity of an amorphous silicon phase, is not more than 2.5, and
adjusting deposition conditions for the crystalline silicon i-layer so that the surface area proportion of those regions for which the Raman peak ratio is not more than 2.5 is not more than 3%.

4. The process for producing a photovoltaic device according to claim 3, wherein conditions for depositing the crystalline silicon i-layer are adjusted so that a surface area proportion of those regions within the substrate plane for which the Raman peak ratio is not less than 3.5 and not more than 8.0 is not less than 80%.

5. The process for producing a photovoltaic device according to claim 3 or claim 4, wherein conditions for depositing the crystalline silicon i-layer are adjusted so that a cell voltage of cells formed on the substrate falls within a predetermined range.

6. The process for producing a photovoltaic device according to any one of claim 3 to claim 5, wherein conditions are adjusted for at least one of a silane partial pressure and a high-frequency electric power density during deposition of the crystalline silicon i-layer.
